# EUROPEAN PATENT APPLICATION

(11) **EP 3 499 583 A1**
(43) Date of publication of application: **19.06.2019**
(21) Application number: 18188970.0
(22) Date of filing: 14.08.2018
(51) Int. Cl.: H01L 31/0392, H01L 31/048, H01L 51/00, H01L 51/44

(54) **METHOD FOR PREPARING INSULATING LAYER OF FLEXIBLE PHOTOVOLTAIC MODULE AND FLEXIBLE PHOTOVOLTAIC MODULE**

(30) Priority: 15.12.2017 CN 201711353184
(71) Applicant: Miasolé Equipment Integration (Fujian) Co., Ltd., 362000 Quanzhou Fujian (CN)
(72) Inventor: YI, Shan, QUANZHOU, Fujian 362000 (CN); XU, Yongyuan, QUANZHOU, Fujian 362000 (CN); HU, Pengchen, QUANZHOU, Fujian 362000 (CN)
(74) Representative: Cabinet Beau de Loménie

(57) **Abstract**

The present disclosure discloses a method for preparing an insulating layer of a flexible photovoltaic module. The method includes: (S1) placing the flexible photovoltaic module on a spraying device, and using a shielding component to shield both side surfaces of the flexible photovoltaic module; (S2) performing a first spraying on the sidewall to be insulated of the flexible photovoltaic module to form an insulating bottom layer; (S3) performing a second spraying on the insulating bottom layer to form an insulating top layer such that the insulating bottom layer and the insulating top layer constitute an insulating layer; and (S4) drying the insulating layer.

## Description

### TECHNICAL FIELD

The present disclosure relates to the technical field of solar cell, in particular to a method for preparing an insulating layer of a flexible photovoltaic module and a flexible photovoltaic module.

### BACKGROUND

With the scarcity of natural resources such as petroleum and coal on the earth, the development of new natural energy has become a top priority. Among them, solar energy has become a major focus of development. At present, the conversion of solar energy into electrical energy that can be used normally uses photovoltaic modules.

The upper surface and the lower surface of the existing photovoltaic module are respectively adhered with a layer of glass, and the sideway of the glass is embodied with an aluminum frame that is grounded to prevent the photovoltaic module from being shocked. However, due to the large self-weight and rigidity of the glass, it has great limitations in practical application. In order to reduce the weight of the photovoltaic module and expand the application range of the photovoltaic module, a flexible photovoltaic module is developed.

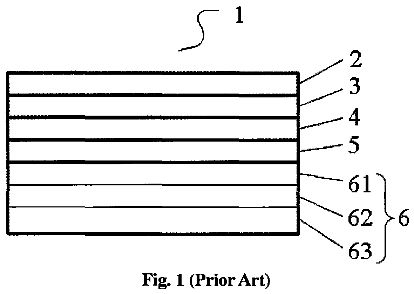

Generally, a flexible photovoltaic module includes, in an order from top to bottom, a PET front plate, a first adhesive film, a battery chip, a second adhesive film, and a PET back plate. In a flexible photovoltaic module, PET (polyethylene terephthalate) is used instead of glass to encapsulate the flexible photovoltaic module. Since the water resistance of PET is insufficient, as shown in FIG. 1, it is necessary to add a layer of aluminum foil with a thickness of about 10µm to 50µm to improve the water resistance performance of the flexible photovoltaic module. In actual production, PET, which is used as back plate, and aluminum foil are often integrated into a composite material layer. The improved flexible photovoltaic module 1 includes, in an order from top to bottom, a PET front plate 2, a first adhesive film 3, a battery chip 4, a second adhesive film 5, and an integrated back plate 6. The integrated back plate 6 includes a first PET 61, an aluminum foil 62, and a second PET 63 in an order from top to bottom.

Due to the limitations of equipment, processes, and costs for producing integrated backplate, at present, aluminum foil edges are generally designed to be flush with PET edges. Therefore, the edges of the aluminum foil are exposed to the air. If the battery chip pierces the integrated backplate, there is a risk of electric leakage. Due to the limitations of flexible photovoltaic modules, such as thin thickness and soft and flexible texture, it is difficult to achieve the grounding of the rigid aluminum frame on the periphery of the flexible photovoltaic module, and it limits the flexibility and bendability of the flexible photovoltaic module to some extent. Therefore, how to solve the problem of electric leakage of the above-mentioned improved flexible photovoltaic module without affecting the flexibility and bendability of the flexible photovoltaic module becomes a matter of urgency.

### SUMMARY

The object of the present disclosure is to provide a method for preparing an insulating layer of a flexible photovoltaic module and a flexible photovoltaic module. In the present disclosure, an insulating layer is prepared on the sideway of the flexible photovoltaic module for insulation, thereby solving the problem of electric leakage of the flexible photovoltaic module.The present disclosure provides a method for preparing an insulating layer of a flexible photovoltaic module, comprising:
step S1: placing the flexible photovoltaic module on a spraying device, and using a shielding component to shield both side surfaces of the flexible photovoltaic module; in particular, placing the flexible photovoltaic module on a spraying device, and using a shielding component to shield the edges of the two side surfaces abutting the sidewall to be insulated of the flexible photovoltaic module;
step S2: performing a first spraying on the sidewall to be insulated of the flexible photovoltaic module to form an insulating bottom layer;
step S3: performing a second spraying on the insulating bottom layer to form an insulating top layer such that the insulating bottom layer and the insulating top layer constitute an insulating layer; and
step S4: drying the insulating layer.

The method for preparing an insulating layer of a flexible photovoltaic module as described above, for example, further comprises step S10 prior to step S1: cleaning the flexible photovoltaic module.

In the method for preparing an insulating layer of a flexible photovoltaic module as described above, for example, step S10 comprises:
step S11: using a dust-free cloth impregnated with isopropyl alcohol to remove oil and grease from the flexible photovoltaic module; and
step S12: dedusting the flexible photovoltaic module by static electricity.

In the method for preparing an insulating layer of a flexible photovoltaic module as described above, for example, step S2 specifically comprises: performing the spraying by using a spray gun and setting the atomizing pressure of the spray gun in a range of about 0.3MPa to 0.5MPa; keeping the distance between the spray gun and the sidewall to be insulated within a range of about 10cm to 15cm during the spraying; forming an insulating bottom layer with a thickness of about 30µm to 40µm.

In the method for preparing an insulating layer of a flexible photovoltaic module as described above, for example, step S3 specifically comprises: performing the spraying by using a spray gun and setting the atomizing pressure of the spray gun in a range of about 0.3MPa to 0.5MPa; keeping the distance between the spray gun and the sidewall to be insulated within a range of about 10cm to 15cm during the spraying; forming an insulating bottom layer; constituting an insulating layer with a total thickness of about 60µm to 100µm by the insulating bottom layer and the insulating top layer.

In the method for preparing an insulating layer of a flexible photovoltaic module as described above, for example, step S4 specifically comprises: placing the flexible photovoltaic module in an infrared light box for about 5 minutes to dry the surface of the insulating layer; placing the flexible photovoltaic module dried by the infrared light box in a dust-free workshop for about 24 hours to naturally dry and solidify the insulating layer.

The method for preparing an insulating layer of a flexible photovoltaic module as described above, for example, further comprises, following step S4, step S5: performing an adhesion test on the formed insulation layer; and/or

step S6: performing an insulation performance test on the formed insulation layer.

The present disclosure also provides a flexible photovoltaic module, wherein an insulating layer is provided on a sidewall of the flexible photovoltaic module.

In the flexible photovoltaic module as described above, for example, the material of the insulating layer is fluoroethylene propylene or methyl vinyl silicon.

In the flexible photovoltaic module as described above, for example, the flexible photovoltaic module comprises, in an order from top to bottom: a PET front plate, a first adhesive film, a battery chip, a second adhesive film and an integrated back plate; and the insulating layer extends from a side of the PET front plate away from the first adhesive film to a side of the integrated back plate away from the second adhesive film.

The present disclosure provides a method for preparing an insulating layer of a flexible photovoltaic module comprising step S1: placing the flexible photovoltaic module on a spraying device, and using a shielding component to shield both side surfaces of the flexible photovoltaic module; step S2: performing a first spraying on the sidewall to be insulated of the flexible photovoltaic module to form an insulating bottom layer; step S3: performing a second spraying on the insulating bottom layer to form an insulating top layer on the insulating bottom layer such that the insulating bottom layer and the insulating top layer constitute an insulating layer; step S4: drying the insulating layer. Using the preparation method of the flexible photovoltaic module insulating layer provided by the disclosure, an insulating layer is prepared on the sidewall of the flexible photovoltaic module, thereby insulating the aluminum foil in the flexible photovoltaic module, avoiding the problem of electric leakage caused by puncturing the aluminum foil by the battery chip, without affecting the flexibility and bendability of the flexible photovoltaic module.

### BRIEF DESCRIPTION OF THE DRAWINGS

FIG. 1 is a schematic structural view of a flexible photovoltaic module in the related art;
FIG. 2 is a flow chart of a method for preparing an insulating layer of a flexible photovoltaic module according to an embodiment of the present disclosure;
FIG. 3 is a schematic view of a use state of a shielding component used in a method for preparing an insulating layer of a flexible photovoltaic module according to an embodiment of the present disclosure, showing the two sideways 101 of four sideways the flexible photovoltaic module;
FIG. 4 is a schematic structural view of a flexible photovoltaic module according to an embodiment of the present disclosure, showing the two side surfaces 102 of the flexible photovoltaic module;
FIG. 5 is a schematic structural view of performing an insulation test on a flexible photovoltaic module according to an embodiment of the present disclosure.

### Description of the reference numerals:

### Related Art:

1 - flexible photovoltaic module, 2 - PET front plate, 3 - first adhesive film, 4 - battery chip, 5 - second adhesive film, 6 - integrated back plate, 61 - first PET, 62 - aluminum foil, 63 - second PET

### The present disclosure:

10 - flexible photovoltaic module, 11 - insulating layer, 12 - PET front plate, 13 - first adhesive film, 14 - battery chip, 15 - second adhesive film, 16 - integrated back plate, 161 - first PET layer, 162 - aluminum foil, 163 - second PET layer, 20 - shielding component, 30 - water tank, 40 - power source, 101 - sidewall, 102 - side surface

### DETAILED DESCRIPTION

The embodiments of the present disclosure are described in detail below, and examples of the embodiments are shown in the accompanying drawings, wherein the same or similar reference numerals denote the same or similar elements or elements having the same or similar functions throughout. The embodiments described below with reference to the drawings are exemplary, are used to explain the present disclosure only, and not intended to limit the present disclosure.

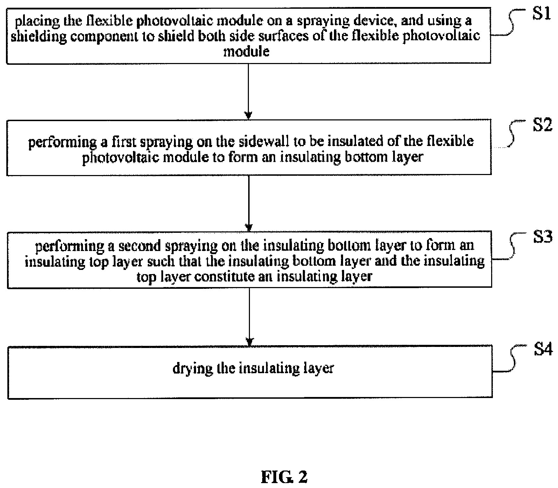

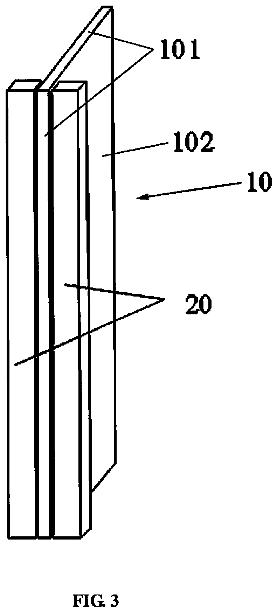

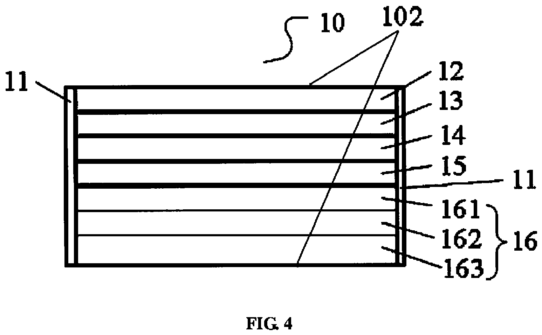

As shown in FIG. 2, the present disclosure will be described with reference to the structural view of the flexible photovoltaic module 10 in FIG. 4, and a method for preparing an insulating layer of a flexible photovoltaic module according to an embodiment of the present disclosure comprises:
Step S1: placing the flexible photovoltaic module 10 on a spraying device, and using a shielding component 20 to shield both side surfaces of the flexible photovoltaic module 10. In particular, placing the flexible photovoltaic module 10 on a spraying device, and using a shielding component 20 to shield the edges of the two side surfaces abutting the sidewall to be insulated of the flexible photovoltaic module 10. The shielding component 20 includes two shielding plates. Specifically, after the flexible photovoltaic module 10 is placed on the spraying device, the two shielding plates are respectively attached to the two side surfaces of the flexible photovoltaic module 10, and the edges of the two shielding plates are all flush with the sidewall to be insulated of the flexible photovoltaic module 10. Referring to FIG. 3, it can be seen that after shielded by the shielding component 20, the flexible photovoltaic module 10 only exposes the sidewall to be insulated, and the peripheral positions are shielded, so as to avoid sputtering the insulating material onto the surface of the flexible photovoltaic module 10 to block the light receiving area and affect the final conversion efficiency when the insulating layer 11 is prepared by spraying. Obviously, the way of shielding the two side surfaces is not limited to this, and thus, any way of avoid sputtering the insulating material onto the surface of the flexible photovoltaic module 1 can be adopted.
Step S2: performing a first spraying on the sidewall to be insulated of the flexible photovoltaic module 10 to form an insulating bottom layer. When spraying, a spray gun is used as the spray tool. The specific method for the first spraying comprises turning on a spray gun and adjusting the atomizing pressure of the spray gun in a range of about 0.3MPa to 0.5MPa; keeping the distance between the spray gun and the sidewall to be insulated within a range of about 10cm to 15cm; subsequently performing a first spraying on the sidewall to be insulated of the flexible photovoltaic module 10 to form an insulating bottom layer with a thickness of about 30µm to 40µm; and turning off the spraying gun.
Step S3: performing a second spraying on the insulating bottom layer to form an insulating top layer so that the insulating bottom layer and the insulating top layer constitute an insulating layer 11. A spray gun is used as the spray tool when spraying. The specific method for the second spraying comprises turning on a spray gun and adjusting the atomizing pressure of the spray gun in a range of about 0.3MPa to 0.5MPa; keeping the distance between the spray gun and the sidewall to be insulated within a range of about 10cm to 15cm; subsequently performing a second spraying on the insulating bottom layer to form an insulating top layer such that the insulating layer 11 that is constituted by the insulating bottom layer and the insulating top layer has a total thickness of about 60µm to 100µm. The second spraying is performed on the basis of the first spraying to continue spraying. The thickness of the insulating top layer of the second spraying is about 30µm to 60µm. The thickness of the two sprayings is totally about 60µm to 100µm. The second spraying makes the insulation layer denser, making up for the holes caused by the uneven first spraying. After the first spraying, the insulating bottom layer is completed, and the second spraying can be performed directly without time interval.
Step S4: drying the insulating layer 11. For example, infrared lamps may be used for drying. Specifically, the flexible photovoltaic module 10 is placed in an infrared light box for about 5 minutes to dry the surface of the insulating layer 11. After being dried, the insulating layer 11 is reliably attached to the flexible photovoltaic module 10 and detachment phenomenon does not occur, such that a good insulation effect can be achieved and the electric leakage phenomenon can be avoided. Certainly, drying is not limited to the above method, and other methods may also be used.

After infrared drying, it is also necessary to place the flexible photovoltaic module 10 in a dust-free workshop for about 24 hours to naturally dry and solidify the insulating layer 11. Drying naturally in the dust-free workshop can further increase the adhesion reliability of the insulating layer 11, and no impurities are mixed in the insulating layer 11, thereby enhancing the insulation effect and increasing the safety factor.

For example, the flexible photovoltaic module 10 can be cleaned prior to placing the flexible photovoltaic module 10 on the spraying device. The cleaning of the flexible photovoltaic module 10 includes the removal of oil, grease, and deposited dust. Specifically, oil and grease on the flexible photovoltaic module 10 can be removed using a dust-free cloth impregnated with isopropyl alcohol; and the flexible photovoltaic module 10 is dedusted by an electrostatic dust removal gun. When cleaning, it is focused on cleaning the sidewall to be insulated of the flexible photovoltaic module 10, so as to prevent the oil, grease and dust from affecting the uniformity of the insulating layer 11, thereby improving the insulation effect and aesthetics. Certainly, the cleansing liquid which impregnates the dust-free cloths is not limited to isopropyl alcohol.

By using the preparation method of the flexible photovoltaic module insulating layer provided by the disclosure, an insulating layer 11 is prepared on the sidewall of the flexible photovoltaic module 10, thereby insulating the aluminum foil 162 in the flexible photovoltaic module 10, avoiding the problem of electric leakage caused by puncturing the aluminum foil 162 by the battery chip, without affecting the flexibility and bendability of the flexible photovoltaic module 10.

In order to increase the life and flexibility of the insulating layer 11, as well as the degree of bendability, the insulating layer 11 is made of polymer nano-composites with high-insulation, high-heat-resistant, and strong-adhesion, such as fluoroethylene propylene, methyl-vinyl-silicon materials or polyurethane compounds with high-adhesion as raw materials.

Those skilled in the art can understand that, the flexible photovoltaic module 10 is generally rectangular with a small thickness. Therefore, it has four sidewalls 101 and two side surfaces 102, wherein all the side walls need to be insulated. After the insulating layer 11 has been prepared for one of the sidewalls, the above steps may be repeated to form the insulating layer 11 for the remaining sidewalls.

After the insulation layer 11 has been formed, its adhesion needs to be tested. Specifically, when the adhesion is tested, the dried flexible photovoltaic module 10 is placed in a test box, in which the humidity is set to about 85%, and the temperature is controlled to increase from about 25°C to 80°C with an increase rate of about 2°C/min. After about 30 min at about 80°C, the temperature is constantly decreased to about -40°C with a cooling rate of about 2°C/min, and maintained at about -40°C for about 30 min. The cycle is repeated about 200 times, after which the insulation layer 11 on the flexible photovoltaic module 10 is checked to see if there are detachment and delamination. If so, the processing technology needs to be adjusted. If not, it is proved that the processing technology is qualified.

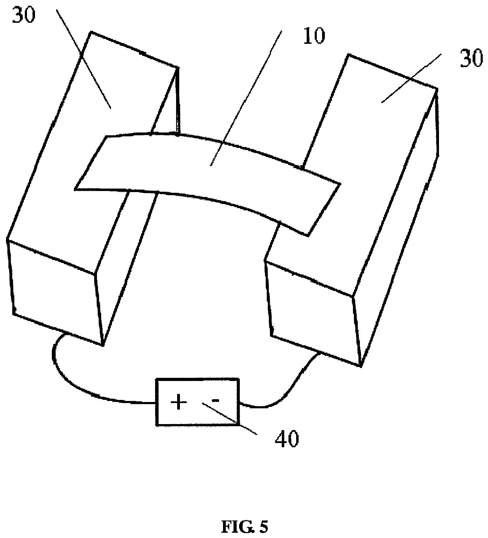

Further, it is also necessary to test the insulation performance of the insulating layer 11. The specific test method is as follows. As shown in FIG. 5, two independent water tanks 30 are prepared, and the conductivity of the water tanks 30 needs to be greater than about 0.286ms/cm². The two sidewalls of the flexible photovoltaic module 10, which are prepared with the insulating layer 11, are respectively placed in two water tanks 30, and then the two water tanks 30 are respectively connected to the positive and negative electrodes of the power source 40, then the leakage current is detected. It is determined whether the leakage current is less than 10µA, if yes, then it is qualified, otherwise, it is unqualified.

As shown in FIG. 4, the present disclosure further provides a flexible photovoltaic module 10, the sidewall of which is provided with an insulating layer 11. For example, the material of the insulating layer 11 is fluoroethylene propylene or methyl vinyl silicon, and it has a thickness of about 60µm to 100µm. Certainly, the specific material of the insulating layer is not limited to the listed ones.

The flexible photovoltaic module 10 includes, in an order from top to bottom, a PET front plate 12, a first adhesive film 13, a battery chip 14, a second adhesive film 15 and an integrated back plate 16. The insulating layer 11 extends from a side of the PET front plate 12 away from the first adhesive film 13 to a side of the integrated back plate 16 away from the second adhesive film 15. For example, the integrated back plate 16 includes, in an order from top to bottom, a first PET layer 161, an aluminum foil layer 162, and a second PET layer 163.

The structures, features, and effects of the present disclosure are described in detail based on the embodiments shown in the drawings. The above description only relates to the preferred embodiments of the present disclosure, but the present disclosure does not limit the scope of implementation as shown in the drawings. Any changes made according to the concept of the present disclosure, or equivalent embodiments that are modified to equivalent changes, should still fall within the protection scope of the present disclosure if they do not go beyond the scope covered by the description and the drawings.

## Claims

1. A method for preparing an insulating layer of a flexible photovoltaic module (10), comprising:
step S1: placing the flexible photovoltaic module (10) on a spraying device, and using a shielding component (20) to shield both side surfaces (102) of the flexible photovoltaic module;
step S2: performing a first spraying on a sidewall (101) to be insulated of the flexible photovoltaic module to form an insulating bottom layer;
step S3: performing a second spraying on the insulating bottom layer to form an insulating top layer such that the insulating bottom layer and the insulating top layer constitute an insulating layer (11); and
step S4: drying the insulating layer (11).

2. The method for preparing an insulating layer of a flexible photovoltaic module (10) according to claim 1, wherein the step S1 is as below:
placing the flexible photovoltaic module (10) on a spraying device, and using the shielding component (20) to shield the edges of the two side surfaces (102) abutting the sidewall (101) to be insulated of the flexible photovoltaic module (10).

3. The method for preparing an insulating layer of a flexible photovoltaic module (10) according to claim 1 further compriseing step S10 prior to step S1: cleaning the flexible photovoltaic module (10).

4. The method for preparing an insulating layer of a flexible photovoltaic module (10) according to claim 3, wherein step S10 comprises:
step S11: using a dust-free cloth impregnated with isopropyl alcohol to remove oil and grease from the flexible photovoltaic module (10); and
step S12: dedusting the flexible photovoltaic module (10) by static electricity.

5. The method for preparing an insulating layer of a flexible photovoltaic module (10) according to claim 1, wherein step S2 comprises:
performing the spraying by using a spray gun and setting the atomizing pressure of the spray gun in a range of about 0.3MPa to 0.5MPa;
keeping the distance between the spray gun and the sidewall (101) to be insulated within a range of about 10cm to 15cm during the spraying; and
forming an insulating bottom layer with a thickness of about 30µm to 40µm.

6. The method for preparing an insulating layer of a flexible photovoltaic module (10) according to claim 1, wherein step S3 comprises:
performing the spraying by using a spray gun and setting the atomizing pressure of the spray gun in a range of about 0.3MPa to 0.5MPa;
keeping the distance between the spray gun and the sidewall (101) to be insulated within a range of about 10cm to 15cm during the spraying;
forming an insulating bottom layer; and
constituting an insulating layer with a total thickness of about 60µm to 100µm by the insulating bottom layer and the insulating top layer.

7. The method for preparing an insulating layer of a flexible photovoltaic module (10) according to claim 1, wherein after step S2 is completed, step S3 is performed directly.

8. The method for preparing an insulating layer of a flexible photovoltaic module (10) according to claim 1, wherein step S4 comprises: placing the flexible photovoltaic module (10) in an infrared light box for about 5 minutes to dry the surface of the insulating layer;
placing the flexible photovoltaic module (10) dried by the infrared light box in a dust-free workshop for about 24 hours to naturally dry and solidify the insulating layer.

9. The method for preparing an insulating layer of a flexible photovoltaic module (10) according to any one of claims 1-6 further comprising step S5 that follows step S4:
performing an adhesion test on the formed insulation layer.

10. The method for preparing an insulating layer of a flexible photovoltaic module according to any one of claims 1-6 further comprising step S6 that follows step S4:
performing an insulation performance test on the formed insulation layer.

11. A flexible photovoltaic module, wherein an insulating layer is provided on a sidewall (101) of the flexible photovoltaic module (10).

12. The flexible photovoltaic module according to claim 11, wherein the material of the insulating layer is fluoroethylene propylene or methyl vinyl silicon.

13. The flexible photovoltaic module according to claim 11, wherein the flexible photovoltaic module comprises, in an order from top to bottom: a PET front plate (12), a first adhesive film (13), a battery chip (14), a second adhesive film (15) and an integrated back plate (16); and
wherein the insulating layer extends from a side of the PET front plate (12) away from the first adhesive film (13) to a side of the integrated back plate away from the second adhesive film (15).

14. The flexible photovoltaic module according to claim 12, wherein the flexible photovoltaic (10) module comprises, in an order from top to bottom: a PET front plate (12), a first adhesive film (13), a battery chip (14), a second adhesive film (15) and an integrated back plate (16); and
wherein the insulating layer extends from a side of the PET front plate (12) away from the first adhesive film (13) to a side of the integrated back plate away from the second adhesive film (15).
